# FASCICULE DE BREVET EUROPEEN

(11) **EP 0 558 401 B1**
(45) Date de publication et mention de la délivrance du brevet: **19.11.1997**
(21) Numéro de dépôt: 93400462.3
(22) Date de dépôt: 23.02.1993
(51) Int. Cl.: G02F 1/136, H01L 21/84, H01L 29/772

(54) **Procédé de fabrication d'un transistor en couches minces à double grille et à masque optique**
Herstellungsverfahren für einen Dünnschichttransistor mit doppeltem Gate und optischer Maske
Manufacturing method for thin film transistor with double gate and optical mask

(30) Priorité: 26.02.1992 FR 9202219
(43) Date de publication de la demande: 01.09.1993
(73) Titulaire: FRANCE TELECOM, 75015 Paris (FR)
(72) Inventeur: Chouan, Yannick, F-22700 Louannec (FR); Bonnel, Madeleine, F-22700 Saint Quay Perros (FR)
(74) Mandataire: Dubois-Chabert, Guy

(56) Documents cités:
- EP-A- 0 082 783
- EP-A- 0 193 759
- PROCEEDINGS OF THE SID, vol. 27, no. 3, 1986, Los Angeles US, pp. 229-234; T. SUNATA et al.: 'A large-area high-resolution active-matrix color LCD addressed by a-Si TFT's'
- APPLIED PHYSICS LETTERS, vol. 50, no. 13, 30 Mars 1987, New York US, pp. 818-820; H. HIRAI et al.: 'Tellurium thin-film transistor deposited on polyester film having plasma polymerized films on double-laered gate insulators'
- PROCEEDINGS OF THE SID, vol. 28, no. 2, 1987, Los Angeles US, pp. 127-130; T. SAKAI et al.: 'An active-matrix-addressed color LCD using a V2-TFT'

## Description

La présente invention a pour objet un procédé de fabrication d'un transistor en couches minces (TCM) à masque optique. Elle trouve une application en microélectronique et en optoélectronique et en particulier dans la réalisation de circuits de commande des écrans plats d'affichage à cristaux liquides.

L'invention permet plus spécifiquement la fabrication de transistors en couches minces à base de silicium amorphe hydrogéné (a-Si:H), utilisés dans les écrans d'affichage à matrice active. En outre, l'invention permet de réaliser des transistors en couches minces à structure "planar" dans une configuration à double grille.

Dans un écran d'affichage à matrice active, on trouve une mémoire électronique formée de points mémoires répartis sur toute la surface de l'écran, qui stoke le signal vidéo pendant toute la durée de l'image. Un transducteur électrooptique est en contact avec chaque point mémoire et est excité pendant toute la durée de l'image.

Dans une matrice active à TCM, chaque point mémoire comprend donc un TCM et un condensateur dont le matériau diélectrique est constitué d'un transducteur électrooptique (par exemple un cristal liquide).

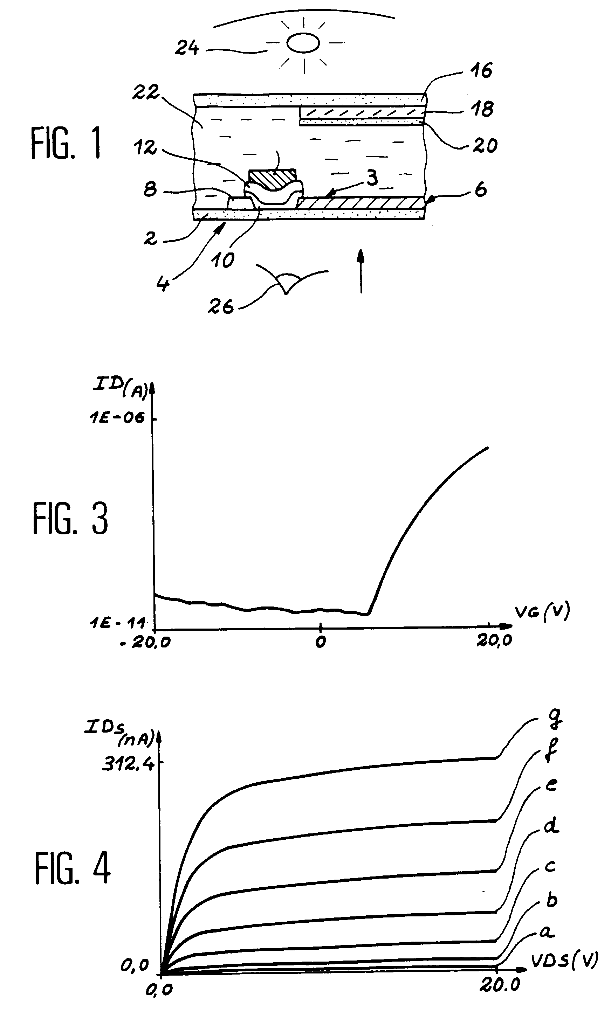

Sur la figure 1, on a représenté schématiquement, en coupe longitudinale, un point mémoire d'un écran plat à matrice active sur substrat de verre.

Sur la figure 1, on voit une plaque inférieure 2 en verre supportant un TCM 4 et une électrode 6 transparente en ITO (oxyde d'indium et d'étain) constituant l'une des armatures du condensateur et le drain 3 du TCM.

Sur la plaque 2, on trouve en outre la source 8 du TCM, réalisée aussi en ITO. Une couche 10 de silicium amorphe hydrogéné constituant la partie active du transistor est en contact électrique avec la source 8 et le drain 3 du TCM. Elle est recouverte d'une couche d'isolant électrique 12 en nitrure de silicium puis d'une grille métallique 14 de commande du transistor en aluminium.

Ce transistor est un transistor à "grille dessus".

L'écran d'affichage comporte en outre une plaque supérieure 16 en verre, recouverte d'une contre-électrode 18 transparente en ITO. Cette contre-électrode 18 est recouverte de filtres colorés 20 dans le cadre d'un affichage en couleur. L'espace prévu entre les deux plaques transparentes 2 et 16 est rempli d'un cristal liquide 22 constituant avec l'électrode 6 et la contre-électrode 18 le condensateur ou point image de l'écran d'affichage.

Cet écran est destiné à être éclairé par l'arrière (ou face supérieure) à l'aide d'une source de lumière 24 du type tube fluorescent et l'affichage est destiné à être observé par un observateur 26 par la face avant (ici la face inférieure).

On constate sur cette figure 1 que le matériau photoconducteur 10 en silicium amorphe hydrogéné du TCM est protégé de la source lumineuse 24 par la grille métallique 14 du transistor. Ainsi, le flux lumineux issu de la source lumineuse 24 est sans effet sur les caractéristiques électriques du TCM.

En revanche, toute source lumineuse placée du côté de l'observateur 26 (par exemple soleil, source lumineuse de poste de travail, etc.) illumine le matériau photoconducteur 10 à travers la plaque support transparente 2 et la qualité du contraste de l'image observée est sensible à l'ambiance lumineuse entourant l'observateur. En effet, si cette lumière est intense, un photocourant est engendré dans la couche 10 diminuant le contraste de l'écran car le rapport Iₒₙ/I_{off} diminue ; Iₒₙ et I_{off} représentent respectivement les courants délivrés par le transistor d'un point affiché et d'un point non affiché.

Un premier objet de l'invention est donc de limiter cet effet en interposant entre le silicium amorphe hydrogéné photoconducteur et la plaque de verre un masque optique.

Dans le document FR-A-2 638 880 déposé au nom de l'Etat Français, il est décrit la réalisation d'un masque optique en polyimide absorbant formé sur la plaque transparente inférieure, entre la source et le drain du transistor et sous le silicium amorphe hydrogéné. Ce masque optique permet en outre l'obtention d'une structure dite "planar".

L'article de T. Sunata et al. "A large-area high-resolution active matrix color LCD addressed by a-Si TFT's", Proceedings of the Society for Information Display (SID) 27 (1986) n°3, p. 229-234 décrit un masque optique constitué d'une couche de chrome gravée interposée entre une couche continue de passivation en nitrure de silicium et la plaque de verre. La couche de passivation sert alors de support pour la matrice active de l'écran.

Cette technique nécessite deux dépôts sous vide ainsi qu'un niveau de masquage spécifique pour définir la forme et l'emplacement du masque optique sous les transistors. Ce niveau de masquage supplémentaire exige une grande précision d'alignement de ce masque par rapport au contact de source et drain des transistors. Cette technique est donc relativement complexe et délicate et par conséquent coûteuse.

L'invention a justement pour but un procédé de fabrication d'un transistor en couches minces à double grille et à masque optique permettant d'éviter les inconvénients ci-dessus. Ce procédé permet la réalisation d'un masquage optique sous le ventre du transistor à double grille tout en réduisant le nombre de niveaux de masquage et en assurant un auto-positionnement de ce masque optique par rapport aux source et drain du transistor.

L'invention a donc pour objet un procédé de fabrication selon la revendication 1 d'un transistor en couches minces comportant une grille inférieure et une grille supérieure, consistant à :
a) déposer une couche d'un premier conducteur sur un substrat isolant électrique, destinée à la réalisation des source et drain du transistor ;
b) réaliser des motifs de résine photosensible sur la couche de premier conducteur fixant l'emplacement et les dimensions des source et drain du transistor ;
c) éliminer les zones de la couche de premier conducteur non recouvertes de résine ;
d) déposer de façon isotrope sur la structure obtenue en c) une couche d'un second conducteur en un métal opaque, destinée à former la grille inférieure du transistor ;
e) effectuer un traitement thermique de la structure obtenue en d) pour effectuer un rétreint des motifs de résine ;
f) déposer de façon isotrope une couche d'un premier isolant électrique sur l'ensemble de la structure obtenue en e) ;
g) dissoudre les motifs de résine afin d'éliminer le second conducteur et le premier isolant hydrogéné déposés sur les motifs de résine ;
h) déposer une couche d'un semi-conducteur sur la structure obtenue en g) ;
i) déposer une couche d'un second isolant électrique sur la couche de semi-conducteur ;
j) déposer une couche d'un troisième conducteur sur la couche de second isolant, destinée à réaliser la grille supérieure du transistor ;
k) photograver l'empilement des couches de troisième conducteur, de second isolant électrique et de semi-conducteur pour fixer les dimensions du transistor ; et
l) passiver la structure obtenue en k) avec un troisième isolant électrique.

Ce procédé permet la réalisation, en une seule étape de pelage (ou d'élimination), d'un masque optique en métal opaque, recouvert d'un isolant électrique sous le "ventre" du transistor.

Ainsi, le procédé de l'invention est parfaitement bien adapté à l'emploi d'un semi-conducteur à propriétés photoconductrices comme par exemple le silicium amorphe hydrogéné renfermant éventuellement du carbone comme décrit dans le document FR-A-2 601 801. Toutefois, du silicium polycristallin peut être envisagé.

Ainsi, lors de l'utilisation du transistor de l'invention dans un écran d'affichage, ce masque optique permet la suppression du photocourant dans ce transistor dû à l'éclairage ambiant de l'écran d'affichage.

Il est connu de l'homme de l'art que l'effet photoconducteur du silicium amorphe hydrogéné est fortement diminué lorsque l'épaisseur du film déposé est très faible, typiquement de 20nm. Malheureusement, le gain obtenu sur cet effet se fait, au détriment de l'intensité de courant Iₒₙ qui, lui, est limité par la faible épaisseur du matériau semi-conducteur.

Le masque optique de l'invention permet, du fait de la limitation de l'effet photoconducteur du a-Si:H, le dépôt de ce semi-conducteur en épaisseur plus importante, typiquement de 200nm ou plus, que celle déposée précédemment et permet donc ainsi d'obtenir un gain potentiel du courant Iₒₙ.

Par ailleurs, ce procédé ne comporte que deux niveaux de masquage, un niveau pour la définition des source et drain du transistor et du masque optique et un niveau pour la définition de la grille supérieure du transistor. Ce procédé est donc compatible avec le procédé de fabrication de matrice active à deux niveaux de masquage décrit dans le document FR-A-2 571 893.

Dans ce type d'application, le substrat isolant et la couche de premier matériau conducteur sont réalisés en matériau transparent à la lumière. En particulier, le substrat est réalisé en verre, en silice ou en plastique transparent tel que le polyméthacrylate de méthyle (PMMA). De même, le premier matériau conducteur est réalisé en oxyde d'étain, en oxyde d'indium ou en ITO.

Le procédé de l'invention permet de plus un auto-positionnement des source et drain du transistor par rapport au masque optique contrairement au procédé décrit dans l'article de T. Sunata ci-dessus.

L'emploi de ce masque optique permet en outre une passivation locale du substrat évitant ainsi la migration des ions du substrat dans le matériau semi-conducteur. Ainsi, un verre de qualité médiocre peut être utilisé.

Dans le cadre de la réalisation d'un écran plat d'affichage, les étapes a) à c) servent aussi à réaliser les lignes conductrices réparties en colonne destinées à la commande de l'écran. De même, l'étape k) sert à réaliser les lignes conductrices de commande de l'écran, disposées perpendiculairement aux colonnes.

De façon avantageuse, le premier et troisième isolants électriques sont réalisés en carbone amorphe hydrogéné.

Les couches de carbone amorphe hydrogéné ou a-C:H sont obtenues à partir d'un plasma radiofréquence constitué uniquement d'hydrocarbures. Ces hydrocarbures sont constitués uniquement de carbone et d'hydrogène comme les alcanes, les alcènes, les alcynes.

Les hydrocarbures utilisables dans l'invention sont des hydrocarbures légers comportant de 1 à 6 atomes de carbone. Ils peuvent être saturés, insaturés ou aromatiques. A titre d'exemple, on peut citer l'acétylène, le propadiène, l'éthylène, le butène, le méthane, l'éthane, le butane. De préférence on utilise le méthane.

Par ailleurs, le dépôt d'a-C:H est effectué à température ambiante.

Afin d'obtenir une structure de transistor "planar", l'empilement métal opaque-carbone amorphe hydrogéné a une épaisseur égale à celle de la couche du premier conducteur.

Comme métal opaque utilisable dans l'invention, on peut citer le chrome, l'argent, le platine, l'aluminium, le nickel-chrome, le cuivre, ... L'épaisseur de ce métal est telle que le coefficient de transmittance (en %) est inférieur à 0,5. Elle est en pratique choisie entre 50 et 150nm.

De façon avantageuse, la couche de métal opaque est déposée par pulvérisation cathodique magnétron. Il est toutefois possible d'utiliser d'autres techniques de dépôt comme l'évaporation thermique.

La technique de dépôt de films minces par pulvérisation cathodique magnétron est connue et utilisée depuis de nombreuses années dans différents domaines.

Cette technique permet d'obtenir des films homogènes en épaisseur sur des substrats de grandes dimensions (de l'ordre du dm² ou du m²) à des vitesses de dépôt élevées (typiquement 100 à 200nm/minutes).

Une des conséquences de l'obtention de ces vitesses de dépôt élevées concerne l'échauffement du substrat qui peut atteindre des températures proches de 100°C.

Dans le procédé de l'invention, le dépôt de métal opaque se faisant sur un substrat partiellement recouvert de résine, on cherche à diminuer au maximum l'effet thermique en alimentant le magnétron à de faibles puissances. Typiquement, la puissance utilisée est de 500 watts, soit environ 10 fois moins que celle utilisée pour le dépôt sur un substrat insensible à la chaleur. Ainsi, le dépôt est effectué à température proche de l'ambiante.

Pour une puissance de 500W et une vitesse de défilement du substrat de 200cm/minute, la vitesse de dépôt obtenue est de 2,5nm/minute. Dans ces conditions, il n'est pas observé de dégradation de la résine.

De façon plus générale, on utilisera dans l'invention une puissance magnétron de 300 à 700 Watts.

Conformément à l'invention, on effectue une étape de traitement thermique destinée au rétreint des motifs de résine. Ce traitement permet d'adapter le profil des motifs de résine réalisés selon la technique de photolithographie.

Cette technique est notamment décrite dans le document "The manufacture of microlenses by melting photoresist" de D. Daly, Meas. Sci. Technol. 1 (1990), p. 759-766.

Le traitement thermique de l'invention permet de contrôler le rétreint de motifs de résine afin de déplacer l'aplomb de ces motifs par rapport au pied des plots de premier matériau gravé.

Ce traitement thermique peut consister en un chauffage au four à une température de 100 à 200°C et mieux de 130°C à 170°C pendant 15 à 40 minutes.

D'autres caractéristiques et avantages de l'invention ressortiront mieux de la description qui va suivre, donnée à titre illustratif et non limitatif.

La description se réfère aux figures annexées dans lesquelles :
- la figure 1, déjà décrite, représente schématiquement, en coupe longitudinale, un point mémoire d'un écran plat à cristal liquide ;
- les figures 2a à 2h illustrent schématiquement, en coupe, les différentes étapes de fabrication d'un transistor conforme à l'invention ;
- la figure 3 donne les caractéristiques de transfert du transistor obtenu selon le procédé de l'invention, c'est-à-dire les variations du courant de drain I_{D} en fonction de la tension de grille V_{G} ;
- la figure 4 donne les variations du courant drain-source en fonction de la tension appliquée entre le drain et la source pour différentes tensions de grille, c'est-à-dire les caractéristiques I_{DS}=f(V_{DS}).

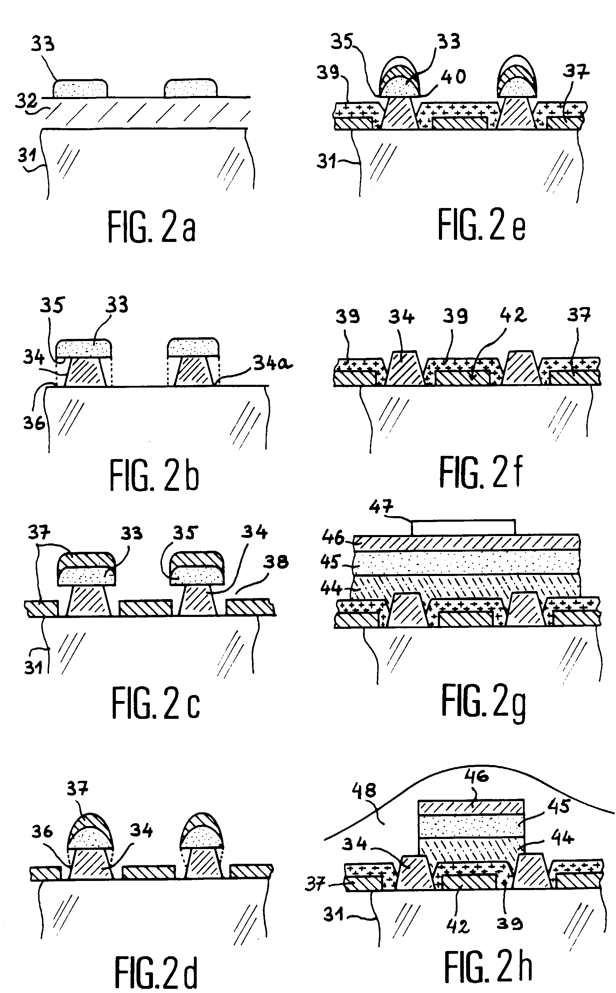

En référence aux figures 2a à 2h, on décrit ci-après la fabrication d'un transistor en couches minces à double grille, utilisable dans les écrans plats d'affichage à cristaux liquides.

Comme représenté sur la figure 2a, on dépose tout d'abord sur un substrat transparent de verre 31 une couche 32 d'oxyde métallique transparent de 25 à 225nm d'épaisseur. Cette couche est par exemple de l'ITO déposé par pulvérisation magnétron sous vide.

Sur cette couche d'ITO, on forme un premier masque de résine photosensible 33 que l'on insole à travers un masque mécanique (non représenté), définissant les motifs à graver dans la couche d'ITO, puis que l'on révèle. En particulier, le masque 33 de résine obtenu masque l'emplacement de la source et du drain du transistor à réaliser.

On effectue alors, comme représenté sur la figure 2b, une gravure de la couche d'oxyde métallique 32 par spray ou dans un bain d'acide chlorhydrique. La gravure est contrôlée en ce qui concerne la concentration de l'agent de gravure, de la température et du temps de gravure afin d'obtenir des motifs 34 d'ITO à flancs 34α inclinés.

En particulier, cette gravure est réalisée avec un bain contenant 37% d'acide chlorhydrique dilué à 50% dans de l'eau et porté à une température de 55°C environ.

Ces flancs inclinés 34a des motifs 34 permettent de dégager un liseré 35 de résine à l'interface ITO/résine.

Les motifs 34 obtenus constituent respectivement la source et le drain du transistor.

La gravure de la couche d'ITO est telle que le pied de chaque plot 34 d'oxyde métallique se trouve en retrait par rapport à l'aplomb 36 des motifs 33 de résine.

On effectue alors, comme représenté sur la figure 2c, un dépôt isotrope à température ambiante d'une couche 37 d'un métal opaque tel que le chrome, sur l'ensemble du substrat. Ce dépôt a une épaisseur de 50 à 150nm. Il est effectué par pulvérisation cathodique magnétron avec une puissance de 500W et une vitesse de défilement du substrat de 200cm/minute.

L'isotropie du dépôt conduit à la formation de métal aussi bien sur le substrat 31 mis à nu que sur les motifs 33 de résine. Ce dépôt isotrope conduit en particulier à la formation d'un film qui est discontinu entre les motifs 33 de résine et le substrat 31. Ces discontinuités portent la référence 38.

Ainsi, on conserve le liseré 35 de résine apparent évitant ainsi tout court-circuit entre les plots 34 d'oxyde métallique et le métal 37 à la surface du substrat 31.

On effectue alors un traitement de la structure obtenue afin d'effectuer un rétreint des plots 33 de résine. La structure obtenue après le traitement thermique est représentée sur la figure 2d.

Ce traitement thermique consiste en un recuit sous étuve à une température de 150°C pendant 30 minutes. Le rétreint est tel que l'aplomb 36 de la résine se trouve maintenant sur les flancs inclinés 34a des plots 34 d'ITO et non plus en pied de plots.

On effectue alors, comme représenté sur la figure 2e, un dépôt isotrope à température ambiante d'une couche 39 de préférence de carbone amorphe hydrogéné sur l'ensemble de la structure. Cette couche 39 a une épaisseur de 10 à 150nm et typiquement de 100nm. Du nitrure de silicium peut éventuellement être utilisé.

L'isotropie du dépôt conduit à la formation d'un film d'a-C:H discontinu entre les motifs 33 de résine recuits et le substrat 31. Les discontinuités portent la référence 40. On conserve ainsi le liseré 35 apparent des motifs 33 de résine.

Le dépôt de carbone amorphe hydrogéné est réalisé en utilisant du méthane pur à une pression de 0,133Pa avec un débit de 20 cm³/min. Ce dépôt est réalisé avec un plasma radiofréquence avec une tension d'auto-polarisation du substrat 31 de 10V.

Dans ces conditions, le film d'a-C:H obtenu possède une résistivité de l'ordre de 10¹² à 10¹³ohms.cm.

Le pelage (ou élimination) de la couche de carbone amorphe s'effectue sans difficulté par dissolution des motifs 33 de résine à partir du liseré 35 apparent, en utilisant de l'acétone ou un dissolvant classiquement utilisé en micro-électronique appelé "posistrip". Ainsi, seuls le carbone 39 et le métal opaque 37 déposés sur le substrat 31 de verre sont conservés, comme représenté sur la figure 2f.

On obtient ainsi un masque optique 42 constitué de métal opaque entre les plots 34 d'ITO respectivement de source et de drain. En dehors du transistor, le métal 37 sert de matériau protecteur du substrat 31.

Les plots de métal opaque 37 sont encapsulés dans du a-C:H. En particulier, du a-C:H est intercalé entre le métal opaque 37, notamment le masque optique, et les plots d'ITO 34 des source et drain du transistor.

De plus, le masque optique 42 constitue une grille inférieure pour le transistor, isolée des source et drain.

En adaptant les épaisseurs du métal optique 37 et de l'isolant électrique 39, il est possible d'obtenir une structure "planar" ; dans ce cas, les contacts de source et drain du transistor présentent alors une épaisseur égale ou proche de celle de l'empilement masque optique 42-carbone amorphe 39.

La fabrication du transistor se poursuit, comme représenté sur la figure 2g, par le dépôt, sur l'ensemble de la structure, d'une couche de silicium amorphe hydrogéné de 50 à 200nm, suivi du dépôt d'une couche d'isolant 45 notamment en nitrure de silicium de 200 à 400nm, puis d'une couche métallique 46 en aluminium ou siliciure d'aluminium de 150 à 250nm.

Ces couches 44, 45 et 46 ont une épaisseur typiquement de 100nm, 300nm et 200nm.

Les couches 44 et 45 sont déposées selon la technique de dépôt chimique en phase vapeur assisté par plasma (PECVD) et la couche 46 est déposée par évaporation sous vide ou mieux, par pulvérisation cathodique.

On définit alors les dimensions du transistor à l'aide d'un second photo-masque de résine 47 obtenu par les procédés classiques de photo-lithographie (insolation à travers un masque puis révélation). Le masque 47 est prévu pour masquer les couches sous-jacentes entre les plots 34 d'ITO.

On effectue alors une gravure anisotrope par voie humide de la couche 46, puis par voie sèche des couches 45 et 44, afin d'éliminer les parties de ces couches non masquées par la résine 47. Les agents d'attaque sont respectivement un plasma de SF₆ pour le silicium amorphe et le nitrure de silicium et un bain d'acide orthophosphorique pour la couche d'aluminium.

Après élimination du photo-masque en résine 47 par voie humide, on passive l'ensemble de la structure par dépôt d'une couche d'isolant électrique 48 sur l'ensemble de la structure. Cette couche 48 est une couche d'a-C:H déposée dans les mêmes conditions que la couche 39 précédemment, ou une couche de nitrure de silicium déposée par LPCVD de 400 à 600 nm d'épaisseur.

On constate que ce procédé de masquage optique et de "planarisation" des contacts de source et drain du transistor ne nécessite pas de niveaux de masquage supplémentaires par rapport aux procédés connus à deux niveaux de fabrication de ces transistors. Ce procédé est donc compatible avec le procédé de fabrication d'un écran d'affichage à matrice active décrit dans le document FR-A-2 571 893.

Ce procédé de fabrication d'un masque optique métallique a donc été intégré à la fabrication de transistors à effet de champ pour commande d'écrans plats à cristaux liquides.

Dans ces conditions, le masque 33 de résine sert de plus à réaliser les colonnes de commande de la matrice active dans la couche d'ITO 32 et le masque 47 sert à réaliser les lignes de commande de la matrice dans la couche métallique 46.

La figure 3 donne les caractéristiques de transfert des transistors obtenus et donc les variations du courant de drain I_{D}, exprimé en ampères, en fonction de la tension V_{G}, exprimée en volts, appliquée à la grille supérieure 46 des transistors.

La figure 4 donne les caractéristiques du courant de drain-source I_{DS} en fonction de la tension appliquée entre le drain et la source V_{DS} pour différentes tensions V_{G} de grille appliquées sur la grille supérieure 46 des transistors. Le courant I_{DS} est exprimé en nanoampères et la tension V_{G} en volts. Les courbes a à g correspondent respectivement à une tension de grille de 10 à 24 volts.

Ces caractéristiques montrent la validité du procédé de l'invention. Elles sont représentatives de l'ensemble des mesures effectuées à l'aide d'un banc de test sous ambiance lumineuse naturelle.

Par ailleurs, des mesures d'absorption optique ont été réalisées sur des films de chrome d'épaisseurs croissantes. Ces mesures montrent qu'une absorption quasi-totale est obtenue pour des films d'épaisseur de 100nm.

Le tableau ci-dessous donne les valeurs des transmittances mesurées pour différentes épaisseurs de chrome en l'éclairant avec une longueur d'onde de 500nm.

| | | | | | | |
|---|---|---|---|---|---|---|
| EPAISSEUR (nm) | 100 | 75 | 50 | 37 | 25 | 12 |
| TRANSMITTANCE (en %) | 10⁻⁵ | 0,05 | 0,43 | 1,38 | 3,86 | 13,96 |

Par ailleurs, on appliquant une polarisation électrique sur le masque métallique 42, les inventeurs ont montré qu'il était possible de moduler le courant Iₒₙ du transistor. En effet, en polarisant le masque optique, on obtient une structure de transistor à double grille définie d'une part par le masque de métal 42 et le carbone amorphe hydrogéné 39 et d'autre part, par le dépôt de nitrure de silicium 45 associé au métal 46 formant la grille habituelle.

Le fonctionnement de telles structures a déjà fait l'objet d'études mais un transistor en couches minces n'a jamais été réalisé, jusqu'à ce jour, avec deux niveaux de masquage. A cet effet, on peut citer les publications "Back-biAs effect on current-voltage characteristics of amorphous silicon thin film transistors" de Y. Kaneto et al., International Conference on Amorphous Semiconductors, 19-23, Août 1991, Garnich - Partenkirchen, Allemagne.

Les tensions appliquées sur la grille inférieure sont indépendantes de celles appliquées sur la grille supérieure.

Ces tensions sont des tensions continues que l'on applique aux transistors de l'écran d'affichage pendant toute la durée de l'affichage des points images correspondants.

## Revendications

1. Procédé de fabrication d'un transistor en couches minces comportant une grille inférieure et une grille supérieure, consistant à :
a) déposer une couche (32) d'un premier conducteur sur un substrat isolant électrique (31), destinée à la réalisation des source et drain (34) du transistor ;
b) réaliser des motifs (33) de résine photosensible sur la couche (32) de premier conducteur fixant l'emplacement et les dimensions des source et drain du transistor ;
c) éliminer les zones de la couche (32) de premier conducteur non recouvertes de résine, de façon que le pied de chaque plot (34) formé à partir de ladite couche (32) se trouve en retrait par rapport à l'aplomb (36) de lesdites motifs (33) de résine ;
d) déposer de façon isotrope sur la structure obtenue en c) une couche (37) d'un second conducteur en un métal opaque, destinée à former la grille inférieure du transistor, ce dépôt isotrope conduit à la formation d'un film qui est discontinu entre les motifs (33) de résine et le substrat (31);
e) effectuer un traitement thermique de la structure obtenue en d) pour effectuer un rétreint des motifs de résine ;
f) déposer de façon isotrope une couche (39) d'un premier isolant électrique sur l'ensemble de la structure obtenue en e) ;
g) dissoudre les motifs de résine afin d'éliminer le second conducteur et le premier isolant déposés sur les motifs de résine ;
h) déposer une couche (44) d'un semi-conducteur sur la structure obtenue en g) ;
i) déposer une couche (45) d'un second isolant électrique sur la couche de semi-conducteur ;
j) déposer une couche (46) d'un troisième conducteur sur la couche de second isolant, destinée à réaliser la grille supérieure du transistor ;
k) photograver l'empilement des couches de troisième conducteur, de second isolant électrique et de semi-conducteur pour fixer les dimensions du transistor ; et
l) passiver la structure obtenue en k) avec un troisième isolant électrique (48).

2. Procédé selon la revendication 1, caractérisé en ce que la couche (39) de premier isolant électrique est en carbone amorphe hydrogéné.

3. Procédé selon la revendication 1 ou 2, caractérisé en ce que la couche (37) de second conducteur est en chrome.

4. Procédé selon la revendication 3, caractérisé en ce que la couche (37) de second conducteur à une épaisseur de 50 à 150nm.

5. Procédé selon l'une quelconque des revendications 1 à 4, caractérisé en ce que la couche (48) de troisième isolant électrique est en carbone amorphe hydrogéné.

6. Procédé selon l'une quelconque des revendications 1 à 5, caractérisé en ce que la couche (37) de second conducteur et la couche (39) de premier isolant électrique empilées ont une épaisseur égale à celle de la couche (32) de premier conducteur.

7. Procédé selon l'une quelconque des revendications 1 à 6, caractérisé en ce que la couche (37) de second conducteur est déposée à température ambiante par pulvérisation cathodique magnétron.

8. Procédé selon l'une quelconque des revendications 2 à 7, caractérisé en ce que le carbone amorphe hydrogéné (39) est déposé à température ambiante par un plasma radiofréquence d'hydrocarbure pur.

9. Procédé selon l'une quelconque des revendications 1 à 8, caractérisé en ce que le traitement thermique consiste à chauffer la structure obtenue en d) à une température de 130°C à 170°C pendant 15 à 40 minutes.

10. Procédé selon l'une quelconque des revendications 1 à 9 de fabrication d'un transistor pour écran d'affichage, caractérisé en ce que la couche (32) de premier matériau conducteur et le substrat (31) sont transparents.

## Patentansprüche

1. Herstellungsverfahren eines Dünnschichttransistors mit einem unteren Gate und einem oberen Gate, folgende Schritte umfassend:
a) Abscheiden einer Schicht (32) eines ersten Leiters auf einem elektrisch isolierenden Substrat (31), bestimmt zur Herstellung von Source und Drain (34) des Transistors;
b) Herstellen von Mustern (33) aus photosensiblem Harz auf der Schicht (32) des ersten Leiters, die Ort und Abmessungen von Source und Drain des Transistors festlegen;
c) Entfernen der nicht mit Harz bedeckten Zonen der Schicht (32) des ersten Leiters, derart daß der Fuß jedes aus besagter Schicht (32) gebildeten Klötzchens (34) zurückversetzt ist in bezug auf die Lotrechte (36) der besagten Muster (33) aus Harz;
d) isotropes Abscheiden, auf der in c) hergestellten Struktur, einer Schicht (37) eines zweiten Leiters aus einem opaken Metall, um das untere Gate des Transistors zu bilden, wobei diese isotrope Abscheidung zur Bildung eines Films führt, der zwischen den Mustern (33) aus Harz und dem Substrat (31) diskontinuierlich ist;
e) Durchführen einer Wärmebehandlung der in d) erhaltenen Struktur, um eine Querschnittsverminderung der Harzmuster zu erreichen;
f) isotropes Abscheiden einer Schicht (39) eines ersten elektrischen Isolators auf der Gesamtheit der in e) erhaltenen Struktur;
g) Auflösen der Harzmuster, um den zweiten Leiter und den ersten Isolator zu entfernen, abgeschieden auf den Harzmustern;
h) Abscheiden einer Schicht (44) eines Halbleiters auf der in g) erhaltenen Struktur;
i) Abscheiden einer Schicht (45) eines zweiten elektrischen Isolators auf der Halbleiterschicht;
j) Abscheiden einer Schicht (46) eines dritten Leiters auf der Schicht des zweiten Isolators, bestimmt zur Herstellung des oberen Gates des Transistors;
k) Photoätzen des Stapels der Schichten aus dem dritten Leiter, dem zweiten elektrischen Isolator und dem Halbleiter, um die Abmessungen des Transistors festzulegen; und
1) Passivieren der in k) erhaltenen Struktur mit einem dritten elektrischen Isolator (48).

2. Verfahren nach Anspruch 1, dadurch gekennzeichnet, daß die Schicht (39) des ersten elektrischen Isolators aus wasserstoffhaltigem amorphem Kohlenstoff ist.

3. Verfahren nach Anspruch 1 oder 2, dadurch gekennzeichnet, daß die Schicht (37) des zweiten Leiters aus Chrom ist.

4. Verfahren nach Anspruch 3, dadurch gekennzeichnet, daß die Schicht (37) des zweiten Leiters eine Dicke von 50 bis 150nm hat.

5. Verfahren nach einem der Ansprüche 1 bis 4, dadurch gekennzeichnet, daß die Schicht (48) des dritten elektrischen Isolators aus wasserstoffhaltigem amorphem Kohlenstoff ist.

6. Verfahren nach einem der Ansprüche 1 bis 5, dadurch gekennzeichnet, daß die Schicht (37) des zweiten Leiters und die Schicht (39) des ersten elektrischen Isolators gestapelt eine Dicke gleich der der Schicht (32) des ersten Leiters haben.

7. Verfahren nach einem der Ansprüche 1 bis 6, dadurch gekennzeichnet, daß die Schicht (37) des zweiten Leiters bei Umgebungstemperatur durch Magnetron-Sputtern abgeschieden wird.

8. Verfahren nach einem der Ansprüche 2 bis 7, dadurch gekennzeichnet, daß der wasserstoffhaltige amorphe Kohlenstoff (39) bei Umgebungstemperatur durch ein Hochfrequenzplasma aus reinem Kohlenwasserstoff abgeschieden wird.

9. Verfahren nach einem der Ansprüche 1 bis 8, dadurch gekennzeichnet, daß die Wärmebehandlung darin besteht, die in d) erhaltene Struktur 15 bis 40 Minuten lang zu wärmen mit einer Temperatur von 130°C bis 170°C.

10. Verfahren nach einem der Ansprüche 1 bis 9 zur Herstellung eines Bildschirm-Transistors, dadurch gekennzeichnet, daß die Schicht (32) aus dem ersten leitenden Material und das Substrat (31) transparent sind.

## Claims

1. Process for the production of a thin film transistor having a lower gate and an upper gate comprising:
a) depositing a layer of a first conductor on an electrical insulating substrate (31) for producing the source and drain (34) of the transistor,
b) producing photosensitive resin patterns (33) on the first conductor layer (32) fixing the location and dimensions of the transistor source and drain,
c) eliminating the areas of the first conductor layer (32) not covered with resin so that the base of each stud (34) formed from said layer (32) is set back relative to the perpendicular (36) of said resin patterns (33),
d) isotropically depositing on the structure obtained in c) a layer (37) of a second conductor constituted by an opaque metal and which will form the lower gate of the transistor, said isotropic deposit leading to the formation of a film which is discontinuous between the resin patterns (33) and the substrate (31),
e) carrying out a heat treatment on the structure obtained in d) in order to bring about a contraction of the resin patterns,
f) isotropically depositing a layer (39) of a first electrical insulant on the complete structure obtained in e),
g) dissolving the resin patterns in order to eliminate the second conductor and the first hydrogenated insulant deposited on the resin patterns,
h) depositing a layer (44) of a semiconductor on the structure obtained in g),
i) depositing a layer (45) of a second electrical insulant on the semiconductor layer,
j) depositing a layer (46) of a third conductor on the second insulant layer for producing the upper gate of the transistor,
k) photoetching the stack of layers constituted by the third conductor, the second electrical insulant and the semiconductor in order to fix the dimensions of the transistor and
l) passivating the structure obtained in k) with a third electrical insulant (48).

2. Process according to claim 1, characterized in that the first electrical insulating material layer (39) is of hydrogenated amorphous carbon.

3. Process according to claim 1 or 2, characterized in that the second conductor layer (37) is of chromium.

4. Process according to claim 3, characterized in that the second conductor layer (37) has a thickness of 50 to 150nm.

5. Process according to any one of the claims 1 to 4, characterized in that the third electrical insulating material layer (48) is of hydrogenated amorphous carbon.

6. Process according to any one of the claims 1 to 5, characterized in that the second conductor layer (37) and the first electrical insulant layer (39) in stacked form have a thickness equal to that of the first conductor layer (32).

7. Process according to any one of the claims 1 to 6, characterized in that the second conductor layer (37) is deposited at ambient temperature by magnetron cathodic sputtering.

8. Process according to any one of the claims 2 to 7, characterized in that the hydrogenated amorphous carbon (39) is deposited at ambient temperature by a radiofrequency plasma of pure hydrocarbon.

9. Process according to any one of the claims 1 to 8, characterized in that the heat treatment consists of heating the structure obtained in d) to a temperature of 130 to 170°C for 15 to 40 minutes.

10. Process according to any one of the claims 1 to 9 for the production of a transistor for a display screen, characterized in that the first conductor material layer (32) and the substrate (31) are transparent.
